# EUROPEAN PATENT APPLICATION

(11) **EP 4 507 458 A1**
(43) Date of publication of application: **12.02.2025**
(21) Application number: 23799537.8
(22) Date of filing: 28.02.2023
(51) Int. Cl.: H05K 1/11, H05K 3/34, H04M 1/02, H05K 3/06

(54) **ELECTRONIC DEVICE INCLUDING INTERPOSER**

(30) Priority: 03.05.2022 KR 20220054895; 01.07.2022 KR 20220081171
(71) Applicant: Samsung Electronics Co., Ltd., Suwon-si, Gyeonggi-do 16677 (KR)
(72) Inventor: PARK, Dohyeong, Suwon-si Gyeonggi-do 16677 (KR); PARK, Junghoon, Suwon-si Gyeonggi-do 16677 (KR); CHUNG, Myungkyoon, Suwon-si Gyeonggi-do 16677 (KR)
(74) Representative: Gulde & Partner
(86) International application number: PCT/KR2023/002750
(87) International publication number: WO 2023/214654

(57) **Abstract**

An interposer Printed Circuit Board (PBC) according to an embodiment may include: an insulating layer which includes a first face and a second face opposite to the first face; a first via group which penetrates the insulating layer to connect the first face and the second face, and includes a plurality of first vias formed spaced apart from each other, the plurality of first vias included in the first via group being used as a first transmission path through which a first signal passes; a first conductive pad which is disposed on the first face to cover first holes of the plurality of first vias, formed on the first face, and is electrically coupled to the plurality of first vias; and a first solder layer which is disposed on the first conductive pad, wherein the first conductive pad extends by a first width in a first direction along the first face of the insulating layer, and wherein the first solder layer extends by a second width smaller than the first width in the first direction.

Various other embodiments understood through the specification are also possible.

## Description

### [Technical Field]

Various embodiments of the disclosure relate to an electronic device including an interposer.

### [Background Art]

While electronic devices are gradually becoming smaller in size, functions of the electronic devices are becoming more diverse. Therefore, it is important to secure a space where electronic parts (e.g., a processor, a communication circuit, or a memory) for performing various functions of the electronic devices are disposed.

Recently, there is a growing demand on electronic devices in which a plurality of printed circuit boards have a stacked structure by using an interposer to secure a space where electronic parts are disposed. For example, since the plurality of printed circuit boards are stacked and the interposer including at least one via for electrically coupling the printed circuit boards are disposed between the stacked printed circuit boards, the electronic device may secure the space where the electronic parts are disposed.

### [Disclosure of Invention]

### [Technical Problem]

According to an embodiment, an interposer Printed Circuit Board (PCB) may include a plurality of vias through which a plurality of electrical signals flow. For example, the interposer PCB may include a first via through which a first electrical signal flows and a second via through which a second electrical signal flows. When the first via and second via formed on the interposer PCB are disposed adjacent to each other, an electrical short problem may occur in that the first electrical signal flowing through the first via flows through the second via. In order to prevent the electrical short problem of the interposer PCB, the first via and second via of the interposer PCB may be formed spaced apart by at least a specific distance, or a first electrode pad which transfers an electrical signal flowing through the via to another PCB or electronic part may be formed spaced apart from a second electrode pad by at least a specific distance.

However, when each via or electrode pad is spaced apart by at least a specific distance, the interposer PCB may increase in size. An increase in an area of the interposer PCB may lead to a decrease in a space where another electronic part (e.g., a battery) is disposed inside the electronic device.

In other words, when a plurality of vias are disposed spaced apart from each other, a space where another electronic part is mounted is insufficient due to an increased size of the interposer PCB, and when the plurality of vias are disposed adjacent to each other, a signal defect may occur due to an electrical short of the interposer PCB. There may be a trade-off relation between the size of the interposer PCB and the occurrence of defective rates caused by the electrical short.

Various embodiments of the disclosure may reduce the defect rate caused by the electrical short of the interposer PCB while reducing a separation distance of the interposer PCB.

### [Solution to Problem]

According to various embodiments of the disclosure, an interposer Printed Circuit Board (PCB) may include an insulating layer which includes a first face and a second face opposite to the first face, a first via group which penetrates the insulating layer to connect the first face and the second face, and includes a plurality of first vias formed spaced apart from each other, the plurality of first vias included in the first via group being used as a first transmission path through which a first signal passes, a first conductive pad which is disposed on the first face to cover first holes of the plurality of first vias, formed on the first face, and is electrically coupled to the plurality of first vias, and a first solder layer which is disposed on the first conductive pad. The first conductive pad may extend by a first width in a first direction along the first face of the insulating layer. The first solder layer may extend by a second width smaller than the first width in the first direction.

According to various embodiments of the disclosure, a method of manufacturing an interposer PCB may include forming a plurality of first vias which penetrate an insulating layer, applying a first conductive material to an inner face of the plurality of vias, injecting an insulating material to the plurality of first vias applied with the conductive material, applying a second conductive material covering holes of the plurality of first vias, to which the insulating material is injected, onto the insulating layer, the holes being formed on both faces of the insulating layer, forming a first conductive pad by etching a second region other than a first region of the insulating layer of which the holes are covered by the second conductive material, and applying a first solder layer, on the formed first conductive pad, with a width narrower than the first conductive pad.

According to various embodiments of the disclosure, an electronic device may include a housing which forms an exterior of at least part of the electronic device, a battery which is disposed to an inner space of the electronic device formed by the housing, and a Printed Board Assembly (PBA) which is disposed between the battery and a side member of the housing in the inner space, the PBA including a first PCB, a second PCB, and an interposer PCB which is disposed between the first PCB and the second PCB to connect the first PCB and the second PCB. The interposer PCB may include an insulating layer which includes a first face and a second face opposite to the first face, a first via group which penetrates the insulating layer to connect the first face and the second face, and includes a plurality of first vias formed spaced apart from each other, the plurality of first vias included in the first via group being used as a first transmission path through which a first signal passes, a first conductive pad which is disposed on the first face to cover holes of the plurality of first vias, formed on the first face, and is electrically coupled to the plurality of first vias, and a first solder layer which is disposed on the first conductive pad. The first conductive pad may extend by a first width in a first direction along the first face of the insulating layer. The first solder layer may extend by a second width smaller than the first width in the first direction.

### [Advantageous Effects of Invention]

According to various embodiments of the disclosure, an electronic device may be provided in which a possibility that an electrical short occurs within an interposer Printed Circuit Board (PCB) decreases without an increase in an area of the interposer PCB.

In addition, according to various embodiments, a decrease in an area of an interposer PCB may lead to an increase in a space where an electronic part is disposed inside an electronic device. Due to an increase in a space where a battery is disposed, the electronic device may include a battery with increased capacity.

In addition, according to various embodiments, the interposer PCB may further include a plurality of vias without an electronic part to be added.

In addition thereto, various effects which are directly or indirectly understood through the disclosure may be provided.

### [Brief Description of Drawings]

FIG. 1 is a front perspective view of an electronic device according to an embodiment;
FIG. 2 is a rear perspective view of an electronic device according to an embodiment;
FIG. 3 is an exploded view of an electronic device according to an embodiment;
FIG. 4 is a cross-sectional view of a Printed Board Assembly (PBA) of an electronic device according to an embodiment;
FIG. 5 is a cross-sectional view of an interposer Printed Circuit Board (PCB) of an electronic device according to an embodiment;
FIG. 6 illustrates a disposition of vias inside the interposer PCB of FIG. 5 according to an embodiment;
FIG. 7 is a cross-sectional view of an interposer PCB of an electronic device according to an embodiment;
FIG. 8 illustrates a disposition of vias in the interposer PCB of FIG. 7 according to an embodiment;
FIG. 9 illustrates a disposition of vias in an interposer PCB according to an embodiment;
FIG. 10 is a flowchart illustrating a process of manufacturing an interposer PCB according to an embodiment; and
FIG. 11 illustrates an electronic device in a network environment according to an embodiment.

With regard to the description of the drawings, the same or similar reference numerals may be used to refer to the same or similar components.

### [Mode for the Invention]

Hereinafter, various embodiments of the disclosure are described with reference to the accompanying drawings. However, it should be appreciated that this is not intended to limit the technological features set forth herein to particular embodiments and include various modifications, equivalents, and/or alternatives for an embodiment of the disclosure.

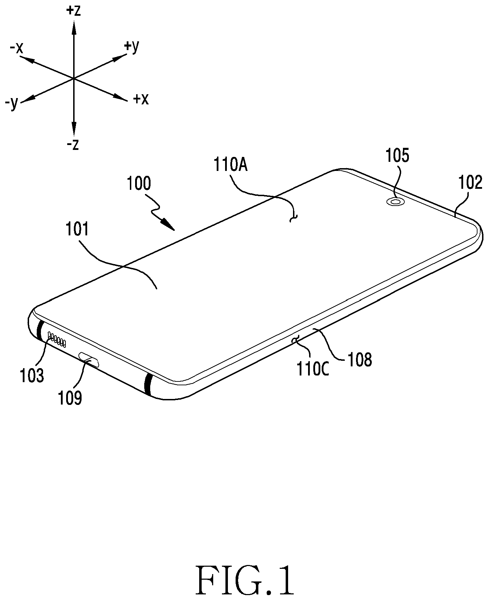

FIG. 1 is a front perspective view of an electronic device according to an embodiment.

Referring to FIG. 1, an electronic device 100 according to an embodiment may include a housing 110 including a first face (or a "front face") 110A, a second face (or a "rear face") 110B, and a side face 110C (or a "sidewall") surrounding a space between the first face 110A and the second face 110B. In an embodiment (not shown), the housing 110 may refer to a structure which constitutes part of the first face 110A, second face 110B, and side face 110C of FIG. 1.

Referring to FIG. 1 according to an embodiment, the first face 110A may be formed of a front plate 102 (e.g., a polymer plate or a glass plate including various coating layers) which is at least partially transparent in practice. According to an embodiment, at least one side edge portion of the front plate 102 may include a curved portion seamlessly extending by being bent from the first face 110A toward a rear plate 111.

According to various embodiments, the side face 110C may be formed of a side member 108 joined to the front plate 102 and the rear plate 111 and including metal and/or polymer. In an embodiment, the rear plate 111 and the side member 108 may be formed integrally and may include the same material (e.g., a metallic material such as aluminum).

According to an embodiment, the electronic device 100 may include at least one of a display 101, an audio module 103, a sensor module (not shown), camera modules 115, 112, 113, and 106, a key input device 117, and a connector hole 109. In an embodiment, at least one of components (e.g., the key input device 117) may be omitted in the electronic device 100, or other components may be additionally included.

In an example, the electronic device 100 may include a sensor module (not shown). For example, the sensor module may be disposed to a rear face of a screen display region of the display 101, viewed to the outside of the electronic device 100 through the front plate 102.

For example, although at least one of an optical sensor, an ultrasonic sensor, and a capacitive sensor may be disposed on the rear face of the screen display region of the display 101, the disclosure is not limited thereto.

In an embodiment, the electronic device 100 may further include a light emitting element, and the light emitting element may be disposed at a location adjacent to the display 101 in the region provided by the front plate 102. The light emitting element may provide, for example, state information of the electronic device 100 in an optical form. In an embodiment, the light emitting element may provide, for example, a light source interworking with an operation of a camera module 105. The light emitting element may include, for example, an LED, an IR LED, and/or a xenon lamp.

According to an embodiment, the display 101 may be viewed to the outside of the electronic device 100 through some portions of the front plate 102. In an embodiment, an edge of the display 101 may be formed to be substantially the same as a shape of a periphery (e.g., a curved face) adjacent to the front plate 102.

According to an embodiment (not shown), the electronic device 100 may have a recess, notch, or opening formed on a portion of a screen display region of the display 101. Various electronic parts, for example, the camera module 105 or a sensor module (not shown) may be disposed to the recess, the notch, or the opening.

According to an embodiment, the audio module 103 may include a microphone hole and a speaker hole. The microphone hole may have a microphone disposed inside thereof to acquire external sound. In an embodiment, a plurality of microphones may be disposed inside the microphone hole to sense a sound direction. According to an embodiment, the speaker hole and the microphone hole may be implemented as a single hole, or the speaker (e.g., a piezo speaker) may be included without the speaker hole. The speaker hole may include an external speaker hole and a communication receiver hole.

The electronic device 100 includes a sensor module (not shown) to generate an electrical signal or data value corresponding to an internal operational state or an external environmental state. The sensor module may further include a proximity sensor disposed to the first face 110A of the housing 110, a fingerprint sensor disposed to the rear face of the display 101, and/or a biometric sensor (e.g., a Heart Rate Monitoring (HRM) sensor) disposed to the second face 110B of the housing 110.

The electronic device 100 may further include at least one of senor modules, for example, a gesture sensor, a gyro sensor, an atmospheric pressure sensor, a magnetic sensor, an acceleration sensor, a grip sensor, a color sensor, an InfraRed (IR) sensor, a biometric sensor, a temperature sensor, a humidity sensor, and an illuminance sensor.

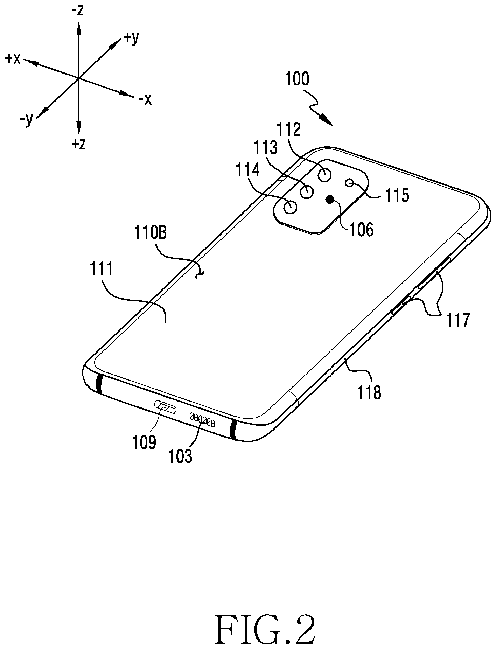

FIG. 2 is a rear perspective view of an electronic device, according to an embodiment,

Referring to FIG. 2 according to an embodiment, the second face 110B may be formed of the rear plate 111 which is opaque in practice. The rear plate 111 may be formed of, for example, coated or colored glass, ceramic, polymer, metallic materials (e.g., aluminum, stainless steel (STS), or magnesium) or a combination of at least two of the materials. According to an embodiment, at least one side edge portion of the rear plate 111 may include a curved portion seamlessly extending by being bent from the second face 110B toward the front plate 102.

According to some embodiments, at least one of the camera modules (e.g., 112, 113, 114, and 115), a fingerprint sensor, and a flash (e.g., 106) may be disposed to the second face 110B. According to an embodiment (not shown), the display 101 may be disposed adjacent to or joined with a touch sensing circuit, a pressure sensor capable of measuring touch strength (pressure), and/or a digitizer for detecting a magnetic-type stylus pen.

The camera modules 105, 112, 113, 114, 115, and 106 may include the first camera module 105 disposed to the first face 110A of the electronic device 100, the second camera modules 112, 113, 114, and 115 disposed to the second face 110B, and/or the flash 106. For example, the camera modules 105, 112, 113, 114, and 115 may include one or more lenses, an image sensor, and/or an image signal processor. The flash 106 may include, for example, a Light Emitting Diode (LED) or a xenon lamp. In an embodiment, two or more lenses (an infrared camera, wide-angle and telephoto lenses) and image sensors may be disposed to one face of the electronic device 100.

According to an embodiment, the key input device 117 may be disposed to the side face 110C of the housing 110. In an embodiment, the electronic device 100 may not include the entirety or part of the aforementioned key input device 117. The key input device 117, which is not included, may be implemented on the display 101 in a different form such as a soft key or the like. In an embodiment, the key input device may include at least part of the fingerprint sensor disposed to the second face 110B of the housing 110.

According to an embodiment, the connector hole 109 may accommodate a connector for transmitting/receiving power and/or data with respect to an external electronic device and/or a connector for transmitting/receiving an audio signal with respect to the external electronic device. For example, the connector hole 109 may include a Universal Serial Bus (USB) connector or an earphone jack. According to an embodiment, the USB connector and the earphone jack may be implemented as a single hole (e.g., 108 of FIG. 1 and FIG. 2). According to an embodiment (not shown), the electronic device 100 may transmit and receive power and/or data with respect to external electronic devices without an additional connector hole, or may transmit and receive an audio signal.

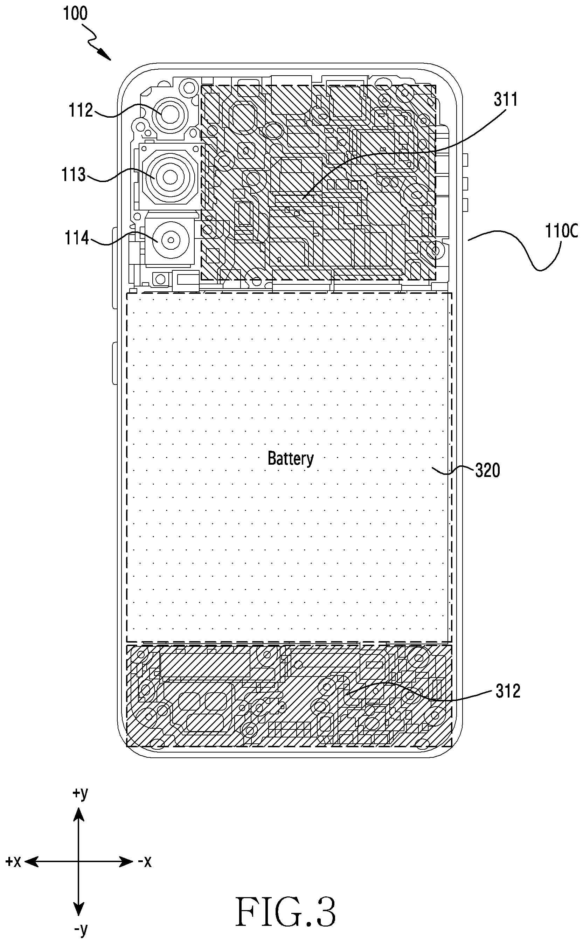

FIG. 3 is an exploded view of an electronic device, according to an embodiment.

According to an embodiment, FIG. 3 illustrates an interior of the second face 110B of the electronic device 100.

According to an embodiment, FIG. 3 illustrates a Printed Board Assembly (PBA) 310 disposed to an inner space of the electronic device 100.

According to an embodiment, the electronic device 100 may include a plurality of electronic parts (e.g., the camera modules 112, 113, and 114, a processor, the PBA 310 electrically coupled to the processor, and a battery 320).

According to an embodiment, the camera modules 112, 113, and 114 may be disposed to a region adjacent to the side face 110C of the electronic device 100, in the inner space of the electronic device 100. For example, the camera modules 112, 113, and 114 may be disposed to be aligned in a row in a first direction (e.g., a negative y-direction) in the inner space adjacent to the side face 110C of the electronic device 100.

According to an embodiment, the processor (not shown) may be disposed to the inner space of the electronic device. According to an embodiment, the processor (not shown) may be electrically coupled to the camera modules 112, 113, and 114 and battery 320 of the electronic device.

According to an embodiment, the PBA 310 may include a first PBA 311 and a second PBA 312.

According to an embodiment, the first PBA 311 may be surrounded by part of the side face 110C of the housing 110, the camera modules 112, 113, and 114, and the battery 320 and disposed to the inner space of the electronic device 100. According to an embodiment, the second PBA 312 may be surrounded by part of the side face 110C of the housing 1110 and the battery 320 and disposed to the inner space of the electronic device 100.

According to an embodiment, the first PBA 311 may be formed of a greater size than the second PBA 312, but the sizes of the first PBA 311 and the second PBA 312 are not limited thereto. As an example, the second PBA 312 may be formed of a greater size than the first PBA 311.

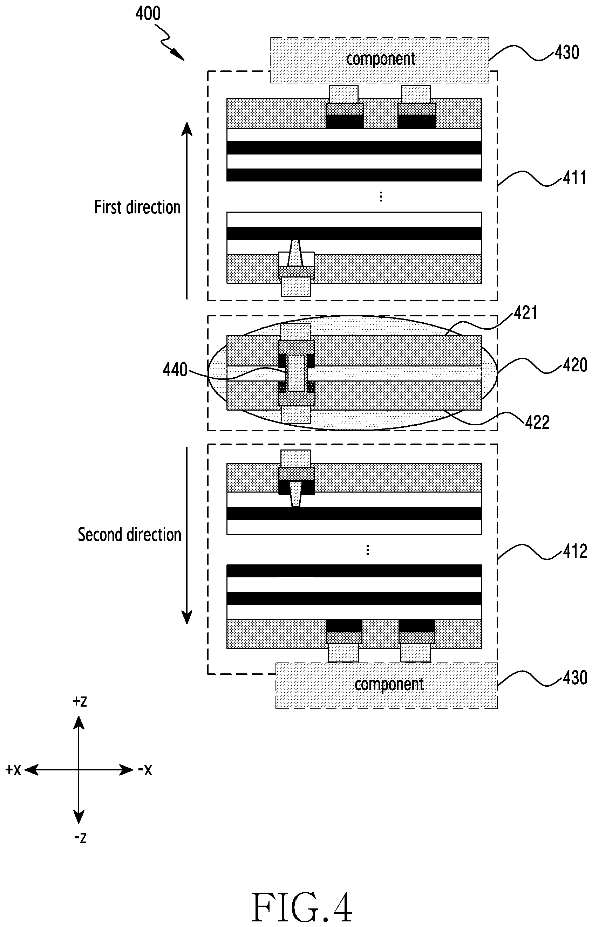

According to an embodiment, the first PBA 311 and the second PBA 312 may include respective interposer PCBs. A specific embodiment related to the interposer PCB will be described below with reference to FIG. 4 to FIG. 10.

According to an embodiment, the battery 320 may be surrounded by the first PBA 311, the second PBA 312, and the side face 110C of the housing 110 and disposed to the inner space of the electronic device 100.

According to an embodiment, a decrease in an area occupied by the first PBA 311 and/or the second PBA 312 in the inner space of the electronic device 100 may lead to an increase in a size of the battery 320.

FIG. 4 is a cross-sectional view of a PBA of an electronic device according to an embodiment.

According to an embodiment, a PBA 400 of FIG. 4 may refer to the first PBA 311 and second PBA 312 of FIG. 3. However, the disclosure is not limited thereto, and the PBA 400 of FIG. 4 may be another PBA included in the electronic device 100.

Referring to FIG. 4, the PBA 400 according to an embodiment may include a first PBC 411, a second PCB 412, and an interposer PCB 420 which couples the first PCB 411 and the second PCB 412.

According to an embodiment, the first PCB 411 may be a circuit board having a first electronic device 431 disposed thereon. For example, a speaker may be disposed on one face of the first PCB 411. According to an embodiment, the second PCB 412 may be a circuit board having a second electronic part 432 disposed thereon. For example, a microphone may be disposed on one face of the second PCB 412.

According to an embodiment, the interposer PCB 420 may couple the first PCB 411 and the second PCB 412. In an example, the interposer PCB 420 may physically couple the first PCB 411 and the second PCB 412. For example, the interposer PCB 420 may be disposed between the first PCB 411 and the second PCB 412. For example, the first PCB 411 may be stacked on the second PCB 412 through the interposer PCB 420.

According to an embodiment, since the PBA 400 includes the interposer PCB 420, the first PCB 411 and the second PCB 412 may be stacked in an inner space of the electronic device 100. For example, since the first PCB 411 and the second PCB 412 are coupled by means of the interposer PCB 420, the first PCB 411 and the second PCB 412 may be disposed to a space corresponding to one axis (e.g., a z-axis) inside the electronic device 100.

According to an embodiment, the first PCB 411 may be disposed to a first face 421 of the interposer PCB 420 facing a first direction (e.g., a positive z-direction), and the second PCB 412 may be disposed to a second face 422 of the interposer PCB 420 facing a second direction (e.g., a negative z-direction) opposite to the first direction.

According to an embodiment, the first electronic part 431 may be disposed on the first PCB 411. For example, the first electronic part 431 may be disposed to one face facing the first direction (e.g., the positive z-direction) of the first PCB 411.

According to an embodiment, the second electronic part 432 may be disposed on the second PCB 412. For example, the second electronic part 432 may be disposed to one face facing the second direction (e.g., the negative z-direction) of the second PCB 412.

For example, the first electronic part 431 may include a power management integrated circuit. For example, the second electronic part 432 may include a battery charger integrated circuit, but the disclosure is not limited thereto.

For example, a cable to be electrically coupled to a battery (e.g., 320 of FIG. 3) may be disposed to one face facing the second direction (e.g., the negative z-direction) of the second PCB 412. For example, a c-clip to be electrically coupled to a wireless communication circuit may be disposed to one face facing the first direction (e.g., the positive z-direction) of the first PCB 411. For example, a plurality of sensors (e.g., vibration sensors) or a speaker may be disposed to one face facing the first direction of the first PCB 411.

According to an embodiment, the electronic device 100 may transfer to the second PCB 412 an electrical signal transferred from the first PCB 411 through the interposer PCB 420. As an example, the electronic device 100 may transfer to the first PCB 411 an electrical signal transferred from the second PCB 412 through the interposer PCB 420. For example, the interposer PCB 420 may transfer to the first PCB 411 or the second PCB 412 an electrical signal through a plurality of vias 440 for transferring the electrical signal.

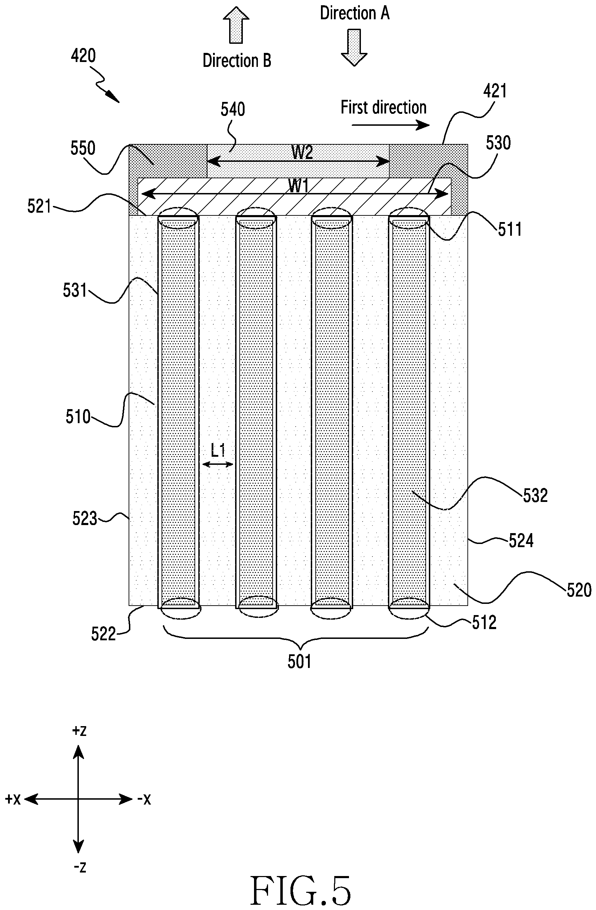

A specific embodiment related to the plurality of vias 440 and the interposer PCB 420 will be described in detail with reference to FIG. 5 to FIG. 10.

Since the interposer PCB 420 couples the first PCB 411 and the second PCB 412, the electronic device 100 may include the first PCB 411 to be disposed to a specific region of an inner space of the electronic device 100 and the second PCB 412 to be coupled to the first PCB 411. For example, since the first PCB 411 and the second PCB 412 are coupled through the interposer PCB 420, the electronic device 100 may include the first PCB 411 and second PCB 412 to be stacked on one axis (e.g., a Z-axis) in a specific space.

FIG. 5 is a cross-sectional view of an interposer PCB of an electronic device according to an embodiment.

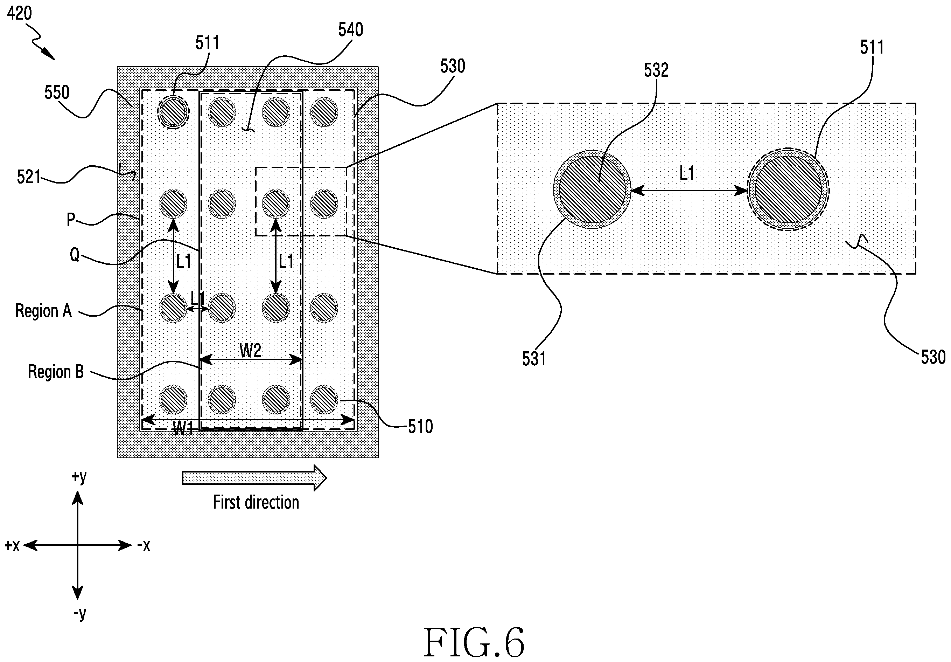

FIG. 6 illustrates a disposition of vias inside the interposer PCB of FIG. 5 according to an embodiment.

According to an embodiment, FIG. 5 illustrates a cross-section (e.g., a xz-plane) of a stacked structure of the interposer PCB 420, and FIG. 6 illustrates a disposition of vias of the interposer PCB 420 of FIG. 5, viewed in a direction A of FIG. 5.

According to an embodiment, the interposer PCB 420 may include a plurality of first vias 510, an insulating layer 520, a first conductive pad 530, and a first solder layer 540.

According to an embodiment, the interposer PCB 420 may include a first via group 501. According to an embodiment, the first via group 501 may be a group including the plurality of first vias 510.

According to an embodiment, spacings between the plurality of first vias inside the first via group 501 may be dense. Since the interposer PCB 420 includes the first via group 501, the interposer PCB 420 may include more vias than another interposer PCB having the same size. According to an embodiment, since the interposer PCB 420 includes the first via group 501, the interposer PCB 420 may include an interposer PCB having a decreased size.

According to an embodiment, the interposer PCB 420 may further include a solder resist 550.

According to an embodiment, the insulating layer 520 may include a first face 521 facing a direction B (e.g., a positive z-direction), a second face 522 opposite to the first face 521 and facing a direction A (e.g., a negative z-direction), and a third face 523 and fourth face 524 perpendicular to the first face 521 and second face 522.

According to an embodiment, the insulating layer 520 may be formed of an insulating adhesive and an insulating material. For example, a region other than a region of the insulating layer 520 formed of the insulating adhesive may be formed of the insulating material.

According to an embodiment, one face of the insulating layer 520 may be formed of the insulating adhesive. In an example, the insulating layer 520 may include an adhesive face to which a conductive member is attached. According to an embodiment, the first face 521 and/or second face 522 of the insulating layer 520 may be formed as an insulating adhesive face, and the third face 523 and the fourth face 524 may be formed as an insulating non-adhesive face. For example, since the first face 521 and/or second face 522 of the insulating layer 520 are formed as the adhesive face, the conductive material or the insulating material may be attached to the first face 521 and/or the second face 522. For example, the first conductive pad 530 described below and the solder resist 550 described below may be attached to the first face 521 and/or second face 522 of the insulating layer.

According to an embodiment, the insulating layer 520 may be formed of the insulating material. For example, a portion between the first face 521 and the second face 522 may be formed of the insulating material in the insulating layer 520. For example, a region inside the insulating layer 520 surrounded by the first face 521, the second face 522, the third face 523, and the fourth face 524 may be formed of the insulating material in the insulating layer 520.

According to an embodiment, the insulating layer 520 may be formed of a polymer material, but the disclosure is not limited thereto. As an example, the insulating layer 520 may be formed by combining glass fiber and epoxy resin.

According to an embodiment, a plurality of vias may be formed on the insulating layer 520.

According to an embodiment, the plurality of first vias 510 may be used as a transmission path through which an electrical signal passes in the interposer PCB 420.

According to an embodiment, the plurality of first vias 510 may refer to the via 440 of FIG. 4.

According to an embodiment, when the plurality of vias are used as a transmission path through which the same signal passes, the plurality of vias used as the transmission path of the same signal may form one via group. For example, the plurality of first vias 510 used as a first transmission path of the same first signal may be referred to as the first via group 501.

According to an embodiment, the single first via group 501 may include 16 first vias 510 used as the first transmission path, but the number of first vias 510 is not limited thereto. As an example, the single first via group 501 may include 4 first vias 510 used as the first transmission path.

According to an embodiment, the plurality of first vias 510 may be formed by penetrating the insulating layer 520. For example, the plurality of first vias 510 may couple the first face 521 and second face 522 of the insulating layer 520 by penetrating the insulating layer 520. For example, the plurality of first vias 510 may be formed by penetrating the insulating layer 520 in perpendicular to the first face 521 and second face 522 of the insulating layer 520.

As an example, the plurality of first vias 510 may extend from the first face 521 to the second face 522 by penetrating the insulating layer 520 with a specific angle against to the first face 521. As an example, the plurality of first vias 510 may be formed as tubes which penetrate the insulating layer 520 in parallel to the third face 523 and the fourth face 524.

According to an embodiment, since the plurality of first vias 510 penetrate the insulating layer 520, first holes 511 and third hole 512 may be formed on the first face 521 and second face 522 of the insulating layer 520. According to an embodiment, since the first holes 511 and the third holes 512 are electrically coupled to the first conductive pad 530 described below, an electrical signal transferred through the plurality of first vias 510 may be transferred to the first conductive pad 530.

According to an embodiment, an insulating material may be applied to an inner face 531 of the plurality of first vias 510. For example, referring to FIG. 5, the plurality of first vias 510 may be formed as a cylindrical pipe. For example, the conductive material may be applied to the inner face 531 of the cylindrical pine of the plurality of first vias 510. As an example, not only the inner face of the cylindrical tube of the plurality of first vias 510 but also an inner space may be filled with the conductive material.

According to an embodiment, since the conductive material is disposed to the inner face of the plurality of first vias 510, the plurality of first vias 510 may be used as a transmission path. For example, an electrical signal transferred from a conductive pad (not shown) disposed to the second face 522 may be transferred to the first conductive pad 530 of the first face 521 along the inner face 531 of the plurality of first vias 510 to which the conductive material is applied.

According to an embodiment, the plurality of first vias 510 may include an insulating material. For example, in the plurality of first vias 510, an inner space 532 other than the inner face of the plurality of first vias 510 to which the conductive material is applied may be filled with the insulating material. For example, referring to FIG. 6, a cross-section of the plurality of first vias 510 may be formed in a circular or elliptical shape. A conductive material is applied along an edge of the inner face 531 of the cross-section of the plurality of first vias 510 formed in the circular or elliptical shape. The inner face 532 other than the edge of the cross-section of the plurality of first vias 510 may be filled with an insulating material. According to an embodiment, the insulating material may be formed of plugging ink, but the disclosure is not limited thereto.

According to an embodiment, since the inner space 532 of the plurality of first vias 510 is filled with the insulating material, rigidity of the plurality of first vias 510 may increase. According to an embodiment, the plurality of first vias 510 may have greater rigidity than the vias of which the inner space 532 is filled with a conductive material.

For example, since the inner space 532 of the plurality of first vias 510 is filled with the insulating material, a possibility that a crack occurs in the cross-section of the plurality of first vias 510 filled with the insulating material may be lower than a possibility that a crack occurs in the plurality of vias of which the inner space 532 is filled with the conductive material.

According to an embodiment, the plurality of first vias 510 in the first via group 501 may be disposed within a specific distance. For example, the plurality of first vias 510 may be disposed within a first separation distance L1.

According to an embodiment, the first separation distance L1 between the plurality of first vias 510 may be determined in consideration of a separation distance required in a manufacturing process. For example, the first separation distance L1 may include a minimum separation distance required to prevent the vias from being damaged in the manufacturing process. For example, since the plurality of first vias 510 are used as a transmission path of the same signal, the first separation distance L1 of the plurality of first vias 510 may be determined in consideration of only the minimum separation distance required to prevent the vias from being damaged in the manufacturing process, without having to consider interference occurring between signals transmitted through the plurality of first vias 510.

According to an embodiment, the first separation distance L1 between the plurality of first vias 510 may be within about 100um to about 200um. For example, the first separation distance L1 between the plurality of first bias 510 may be 150um, but the first separation distance L1 is not limited thereto. As an example, the first separation distance L1 between the plurality of first vias 510 may be shorter than about 100um or longer than about 200um.

According to an embodiment, although it is illustrated in FIG. 6 that the first separation distance L1 between the plurality of first vias 510 is formed in a first direction (e.g., a y-direction), the disclosure is not limited thereto. As an example, the first separation distance L1 may be formed in a second direction (e.g., a x-direction). As an example, the first separation distance L1 may be formed of a length between one first via among the plurality of first vias 510 and another first via located in a diagonal direction (e.g., a xy-direction).

According to an embodiment, the first via group 501 may be used as a first transmission path through which a first signal is transferred.

According to an embodiment, since the single first via group 501 is used as the first transmission path of the same first signal, there may be no problem even if an electrical short of the first signal occurs between the plurality of first vias 510. For example, even if the first signal transferred from one via among the plurality of first vias 510 is transferred to another via among the plurality of first vias 510, a signal interference problem may not occur.

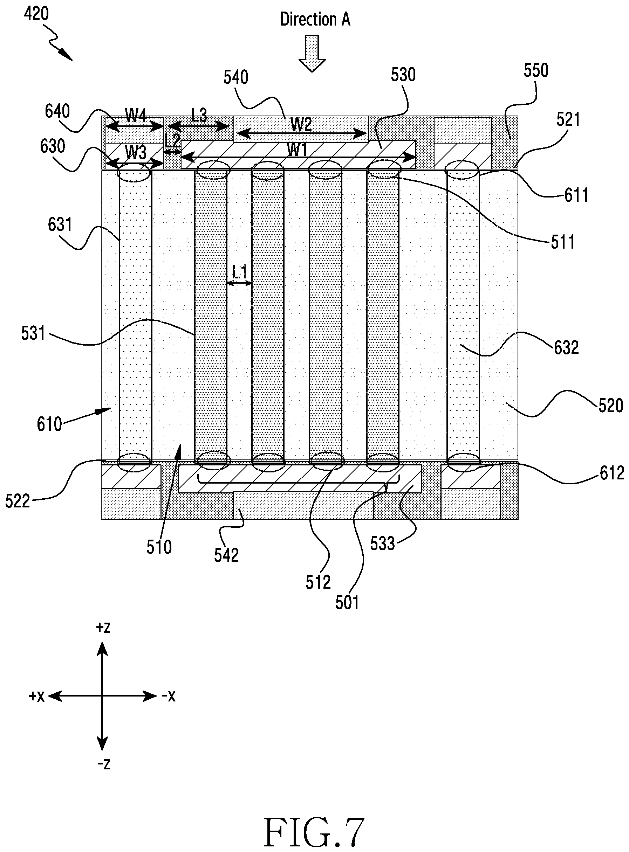

According to an embodiment, since the electrical short problem of the first signal does not occur between the plurality of first vias 510, the first separation distance L1 between the plurality of first vias 510 may be shorter than a separation distance between a via (e.g., the second via 610 of FIG. 7) used as a second transmission path of a different second signal and the plurality of first vias 510.

According to an embodiment, a decrease in the first separation distance L1 between the plurality of first vias 510 may lead to a decrease in a size of the interposer PCB 420. As an example, since the first separation distance L1 between the plurality of first vias 510 decreases, the interposer PCB 420 may include more vias than the interposer PCB having the same length.

According to an embodiment, since there is no problem even if the electrical short of the first signal occurs between the plurality of first vias 510, the plurality of first vias 510 may be electrically coupled to one first conductive pad 530. For example, the single first conductive pad 530 may cover the plurality of first vias 510.

According to an embodiment, the first conductive pad 530 may be disposed on the first face 521 of the insulating layer 520 of the interposer PCB 420.

According to an embodiment, the first conductive pad 530 may transfer to a first PCB (e.g., the first PCB 411 of FIG. 4) or a second PCB (e.g., the second PCB 412 of FIG. 4) an electrical signal transferred through the plurality of first vias 510. For example, the first conductive pad 530 may include an electrode pad which covers at least one via. For example, since the first conductive pa 530 may be electrically coupled to a conductive material applied to the inner face 531 of the plurality of first vias 510, the first conductive pad 530 may transfer to the first PCB 411 the first signal transferred through the plurality of first vias 510. For example, the first conductive pad 530 may transfer to the plurality of first vias 510 the first signal transferred from the first solder layer 540.

According to an embodiment, the first conductive pad 530 may be formed integrally with the inner face 531 of the plurality of first vias 510. For example, the first conductive pad 530 may be formed integrally with the inner face 531 of the plurality of first vias 510 in a manufacturing process. For example, the first conductive pad 530 may be formed of the same material as a conductive material applied to the inner face 531 of the plurality of first vias 510. According to an embodiment, since the first conductive pad 530 is formed integrally with the inner face 531 of the plurality of first vias 510, the first conductive pad 530 may transfer to the first PCB 411 or the second PCB 412 the first signal transferred through the plurality of first vias 510.

According to an embodiment, the first conductive pad 530 may include a conductive plating and a conductive foil. For example, since the conductive plating is disposed on the conductive foil, the first conductive pad 530 may be formed.

According to an embodiment, the first conductive pad 530 may be formed of copper (CU). For example, the first conductive pad 530 may be formed by combining a copper foil and a copper plating stacked on the copper foil. However, a material constituting the first conductive pad 530 is not limited to copper.

According to an embodiment, the first conductive pad 530 may be disposed to a region of the first face 521 of the insulating layer 520. For example, the first conductive pad 530 may be formed on a region corresponding to the first holes 511 of the plurality of first vias 510 formed on the first face 521 of the insulating layer 520. For example, the first conductive pad 530 may be formed on a region covering the first holes 511 of the plurality of first vias 510 included in the first via group 501.

According to an embodiment, although it is illustrated that the first conductive pad 530 is disposed to a region of the first face 521 of the insulating layer 520, the disclosure is not limited thereto. For example, the first conductive pad 530 may be formed on a region corresponding to the second holes 512 of the second face 522 to cover the second holes 512.

According to an embodiment, since the single first via group 501 is used as the first transmission path of the same first signal, there may be no problem even if an electrical short of the first signal occurs between the plurality of first vias 510. For example, even if the first signal transferred from one via among the plurality of first vias 510 is transferred to another via among the plurality of first vias 510, a signal interference problem may not occur.

According to an embodiment, since the electrical short problem of the first signal does not occur between the plurality of first vias 510, the single first conductive pad 530 may cover the plurality of first vias 510.

Referring to FIG. 6 according to an embodiment, the first conductive pad 530 may be formed as a single conductive pad to cover all of the first holes 511. For example, the first via group 501 may be included in a region (a region A) of the insulating layer 520 having the first conductive pad 530 formed thereon. For example, when viewed from the direction A of FIG. 5, the first conductive pad 530 may be overlapped with the first holes 511 of the plurality of first vias 510.

Referring to FIG. 6, the first conductive pad 530 may cover the 4x4 first holes 511 in the first via groups 501, but the number of first holes 511 is not limited thereto. As an example, the single first conductive pad 530 may cover the 3x4 first holes 511 in the first via groups 501.

According to an embodiment, since the single first conductive pad 530 covers the plurality of first vias 510, the first solder layer 540 described below may be formed of a narrower width than the first conductive pad 530. For example, even if the first solder layer 540 is formed of the narrower width than the first conductive pad 530, a signal transferred from the plurality of first vias 510 may be transferred to the first soler layer 540 through the first conductive pad 530.

According to an embodiment, the first solder layer 540 may be disposed on the first conductive pad 530 of the interposer PCB 420.

According to an embodiment, the first solder layer 540 may include an electrical coupling member. For example, the first solder layer 540 may transfer to the electronic part 430 disposed inside the electronic device 100, a first PCB (e.g., the first PCB 411 of FIG. 4), or a second PCB (e.g., second PCB 412 of FIG. 4) the first signal transferred from the plurality of first vias 510 and the first conductive pad 530.

According to an embodiment, the first solder layer 430 may further include an adhesive member. For example, the first PCB (e.g., the first PCB 411 of FIG. 4) may be attached to one face of the interposer PCB 420 by means of the first solder layer 540.

According to an embodiment, the first solder layer 540 may be stacked on the first conductive pad 530. For example, referring to FIG. 6, the first solder layer 540 may be disposed on a region (a region B) of the first conductive pad 530. For example, when the first conductive pad 530 covers the plurality of first vias 510, the first solder layer 540 may be disposed to a region corresponding to some of the plurality of first vias 510 covered by the first conductive pad 530, on the first conductive pad 530. For example, referring to FIG. 6, the first conductive pad 530 may cover the plurality of (i.e., 4x4) first vias 510. For example, the first solder layer 540 may be disposed on the region (the region B) of the first conductive pad 530 which covers the plurality of (i.e., 4x2) first vias 510.

According to an embodiment, the first solder layer 540 may be formed of a width different from that of the first conductive pad 530. For example, the first conductive pad 530 may extend by a first width W1 in a first direction (e.g., a positive x-direction) along the first face 521 of the insulating layer 520. For example, the first solder layer 540 may extend by a second width W2 in the first direction (e.g., the positive x-direction) along one face of the first conductive pad 530.

According to an embodiment, the second width W2 of the first solder layer 540 may be smaller than the first width W1 of the first conductive pad 530. For example, the second width W2 of the region B on which the first solder layer 540 is formed may be smaller than the first width W1 of the region A on which the first conductive pad 530 is formed.

According to an embodiment, the first width W1 may mean a length extending from a first edge P of the first conductive pad 530 in the first direction (e.g., the positive x-direction), and the second width W2 may mean a length extending from a second edge Q of the first solder layer 540 in the first direction (e.g., the positive x-direction).

According to an embodiment, since the width of the first soler layer 540 decreases, a separation distance between the first solder layer 540 and a different second solder layer (not shown) may be secured. According to an embodiment, since the separation distance between the first solder layer 540 and the different second solder layer is secured, an electrical short may be avoided between the first solder layer 540 and the second solder layer. For example, a possibility that the first signal transferred through the first solder layer 540 is transferred to the second solder layer may be reduced.

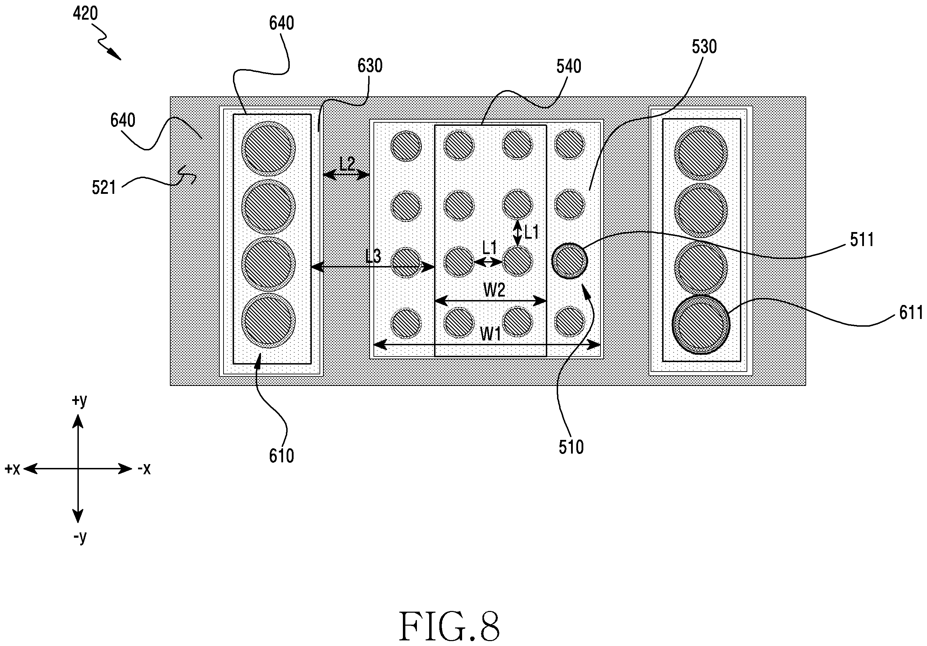

An embodiment for a separation distance (e.g., the third separation distance L3 of FIG. 7) between the first solder layer 540 and a second solder layer (not shown) will be described in detail with reference to FIG. 7 and FIG. 8.

According to an embodiment, the interposer PCB 420 may further include the solder resist 550. For example, the solder resist 550 may be disposed on the first face 521 of the insulating layer 520. For example, the solder resist 550 may be formed in a space where the first conductive pad 530 and the first solder layer 540 are not disposed, on the first face 521 of the insulating layer 520. For example, referring to FIG. 5 and FIG. 6, the solder resist 550 may be formed by surrounding the first conductive pad 530 and the first solder layer 540, on the first face of the insulating layer 520.

According to an embodiment, since the solder resist 550 is formed in the space where the first conductive pad 530 and the first solder layer 540 are not disposed, the first face 421 of the interposer PCB 420 may be formed to be flat.

According to an embodiment, since the solder resist 550 is formed in the space where the first conductive pad 530 and the first solder layer 540 are not disposed, the first solder layer 540 may be prevented from being spread in the first direction (e.g., the positive x-direction or the negative x-direction) in a process of manufacturing the interposer PCB 420. For example, the first conductive pad 530 may be prevented from being formed of a wider width than the first width W1. For example, the first solder layer 540 may be prevented from being formed of a wider width than the second width W2.

According to an embodiment, the first via group 501 may be disposed to a region of the insulating layer 520 adjacent to an electronic part disposed inside the electronic device 100. For example, the first via group 501 may be formed at a portion of the insulating layer 520 adjacent to a power Integrated Circuit (IC) or battery charger IC disposed to an inner space of the electronic device 100.

Referring to FIG. 5 and FIG. 6 according to an embodiment, although is it illustrated that the interposer PCB 420 has structures each having a square cross-section, the cross-section of the interposer PCB 420 is not limited thereto. For example, a cross-section of the first solder layer 540 of the interposer PCB 420 may be formed in an elliptical shape.

FIG. 7 is a cross-sectional view of an interposer PCB of an electronic device according to an embodiment.

FIG. 8 illustrates a disposition of vias in the interposer PCB of FIG. 7 according to an embodiment.

According to an embodiment, FIG. 7 and FIG. 8 illustrate a disposition relation between the plurality of first vias 510 and a second via 610. For example, FIG. 7 and FIG. 8 illustrate an embodiment for a third separation distance L3 between the first solder layer 540 and a second solder layer 640. For example, as shown in FIG. 7 and FIG. 8, a second via may be formed around the first vias of FIG. 5 and FIG. 6.

According to an embodiment, the interposer PCB 420 of FIG. 7 and FIG. 8 may further include the second via 610, a third conductive pad 533 disposed to the second face 522 of the insulating layer 520, and a third solder layer 542.

According to an embodiment, referring to FIG. 7 and FIG. 8, the third separation distance L3 between the second solder layer 640 and the first solder layer 540 may be longer than a second separation distance L2 between a second conductive pad 630 and the first conductive pad 530. According to an embodiment, since the third separation distance L3 is formed to be longer than the second separation distance L2, the first conductive pad 530 and the second conductive pad 630 may be disposed adjacent to each other on the insulating layer 520, while preventing an electrical short between the first solder layer 540 and the second solder layer 640.

According to an embodiment, the same explanation as in the embodiment of the interposer PCB 420 of FIG. 5 and FIG. 6 will be omitted in the description of FIG. 7 and FIG. 8. For example, an embodiment related to the plurality of first vias 510, insulating layer 520, and soler resist 550 of FIG. 7 and FIG. 8 may refer to the plurality of first vias 510, insulating layer 520, and solder resist 550 of FIG. 5 and FIG. 6.

For example, since the interposer PCB 420 includes the plurality of first vias 510 having the first separation distance L1, the interposer PCB 420 may decrease in size. According to an embodiment, since the separation distance between the plurality of first vias 510 decreases, the interposer PCB 420 may include more vias than the interposer PCB having the same size.

According to an embodiment, the interposer PCB 420 may further include the third conductive pad 533 disposed on the second face 522 of the insulating layer 520, and the third solder layer 542.

According to an embodiment, the interposer PCB 420 may further include the second via 610, the second conductive pad 630, and the second solder layer 640.

According to an embodiment, the interposer PCB 420 may further include the second via 610 used as a transmission path through which an electrical signal passes.

According to an embodiment, the second via 610 may be formed by penetrating the insulating layer 520. For example, the second via 610 may penetrate the insulating layer 520 to couple the first face 521 and second face 522 of the insulating layer 520. For example, the second via 610 may be formed by penetrating the insulating layer 520 in perpendicular to the first face 521 and second face 522 of the insulating layer 520, but the disclosure is not limited thereto. As an example, the second via 610 may extend from the first face 521 to the second face 522 by penetrating the insulating layer 520 with a specific angle against the first face 521. As an example, the second via 610 may be formed as a tube which penetrates the insulating layer 520 in parallel to the third face 523 and the fourth face 524.

According to an embodiment, the second via 610 may be formed substantially to be the same as the plurality of first vias 510. For example, since the second via 610 penetrates the insulating layer 520, the second via 610 may include the first face 521 of the insulating layer 520, and a second hole 611 and fourth hole 612 formed on the second face 522. For example, a conductive material may be applied to an inner face 631 of the second via 610, and an inner space 632 other than the inner face of the second via 610 may be filled with an insulating material.

According to an embodiment, the second via 610 may be used as a second transmission path through which a second signal passes. For example, since a conductive material is applied to the inner face 631 of the second via 610, the second via 610 may be used as the second transmission path for transferring the second signal. For example, the second signal transferred through the second via 610 may be different from a first signal transferred through the plurality of first vias 610.

According to an embodiment, since the second via 610 is used as a signal transmission path different from that of the plurality of first vias 510, the second via 610 may be disposed spaced apart from the plurality of first vias 510. For example, since the second via 610 is disposed spaced apart from the plurality of first vias 510, an electrical short problem between the plurality of first vias 510 and the second via 610 may be avoided. For example, since the second via 610 is used as a transmission path of the second signal different from the first signal, the second via 610 may be disposed spaced apart from the first via group 501 by at least a specific distance in order to prevent the second signal, which passes through the second via 610, from being transferred to the plurality of first vias 510.

According to an embodiment, the interposer PCB 420 may further include the second conductive pad 630 disposed on the first face 521 of the insulating layer 520.

According to an embodiment, the second conductive pad 630 may refer to part of the first conductive pad 530. For example, the second conductive pad 630 may include an electrode pad. For example, the second conductive pad 630 may cover the second hole 611 and/or fourth hole 612 of the second via 610.

According to an embodiment, the second conductive pad 630 may transfer to a first PCB (e.g., the first PCB 411 of FIG. 4) and a second PCB (e.g., the second PCB 412 of FIG. 4) a second electrical signal transferred through the second via 610. For example, since the second conductive pad 630 is electrically coupled to a conductive material applied to the inner face 631 of the second via 610, the second conductive pad 630 may transfer to the first PCB (e.g., the first PCB 411 of FIG. 4) or the second PCB (e.g., the second PCB 412 of FIG. 4) the second signal transferred through the second via 610.

According to an embodiment, the second conductive pad 630 may be formed integrally with the inner face 631 of second via 610. For example, the second conductive pad 630 may be formed integrally with the inner face 631 of the second via 610 in a manufacturing process. For example, the second conductive pad 630 may be formed of the same material as a conductive material applied to the inner face 631 of the second via 610.

According to an embodiment, since the second conductive pad 630 is formed integrally with the inner face 631 of the second via 610, the second conductive pad 630 may transfer to a first PCB (e.g., the first PCB 411 of FIG. 4) or a second PCB (e.g., the second PCB 412 of FIG. 4) the second signal transferred through the second via 610.

According to an embodiment, the second conductive pad 630 may be disposed to a region of the first face 521 of the insulating layer 520. For example, the second conductive pad 630 may be disposed to a region other than a region where the first conductive pad 530 is not disposed on the first face 521 of the insulating layer 520. For example, the first conductive pad 530 may be disposed to a region on the first face 521 of the insulating layer 520, and the second conductive pad 630 may be disposed to another region on the first face 521 of the insulating layer 520. For example, the first conductive pad 530 and the second conductive pad 630 may not overlap on the first face 521 of the insulating layer 520.

For example, the second conductive pad 630 may be formed on a region corresponding to the second hole 611 of the second via 610 formed on the first face 521 of the insulating layer 520. For example, referring to FIG. 8, the second conductive pad 630 may be formed on the insulating layer 520 to cover the second hole 611. For example, when viewed from the direction A of FIG. 7, the second conductive pad 630 may be overlapped with the second hole 611 of the second via 610. The second conductive pad 630 may cover the second hole 611 of the second via 610 aligned in the form of 4x1, but the number of second vias 610 is not limited thereto.

According to an embodiment, the interposer PCB 420 may further include the second solder layer 640 disposed on the second conductive pad 630.

According to an embodiment, the second solder layer 640 may transfer to the electronic part 430 disposed inside the electronic device 100, the first PCB (e.g., the first PCB 411 of FIG. 4), or the second PCB (e.g., second PCB 412 of FIG. 4) the second signal transferred from the second via 610 and the second conductive pad 630.

According to an embodiment, the second solder layer 640 may be stacked on the second conductive pad 630. For example, referring to FIG. 8, the second solder layer 640 may be disposed on the second conductive pad 630. For example, when the second conductive pad 630 covers the second via 610, the second solder layer 640 may cover the second conductive pad 630. For example, when viewed from the direction A of FIG. 7, the second solder layer 640 may be overlapped with the second conductive pad 630.

According to an embodiment, the second solder layer 640 may be formed of a third width W3 equally to the second conductive pad 630. For example, the second conductive pad 630 may extend by the third width W3 in a first direction (e.g., a positive x-direction) along the first face 521 of the insulating layer 520. For example, the second solder layer 640 may extend by the third width W3 in the first direction (e.g., the positive x-direction) along one face of the second conductive pad 630.

According to an embodiment, the second solder layer 640 is formed of the third width W3 equally to the second conductive pad 630, but the disclosure is not limited thereto. As an example, the second solder layer 640 may be formed of a fourth width (not shown) smaller than the second conductive pad 630.

According to an embodiment, the third width W3 and a fourth width W4 may refer to the first width W1 and second width W2 of FIG. 5 and FIG. 6.

According to an embodiment, the third separation distance L3 between the first solder layer 540 and the second solder layer 640 may be greater than the second separation distance L2 between the first conductive pad 530 and the second conductive pad 630.

When respective solder layers which transfer different signals are disposed adjacent to each other, a signal may be transferred to a solder layer which transfers another signal. For example, when a first solder layer which transfers a first signal is disposed adjacent to a second solder layer which transfers a second signal, the first signal may be transferred to the second solder layer. When the first signal is transferred to the second solder layer, the electronic device 100 may operate erroneously.

According to an embodiment, the first solder layer 540 and the second solder layer 640 may be spaced apart by the third separation distance L3.

According to an embodiment, the third separation distance L3 may be within about 350um to about 550 um. For example, the third separation distance L3 may include about 400um, but the disclosure is not limited thereto. As an example, the third separation distance L3 may be greater than 550 um. As an example, the third separation distance L3 may be less than 350um.

According to an embodiment, the second conductive pad 630 which covers the second via 610 may be spaced apart from the first conductive pad 530 which covers the plurality of first vias 510 by the second separation distance L2 less than the third separation distance L3.

According to an embodiment, the second separation distance L2 may be within about 50um to about 150um. For example, the second separation distance L2 may include about 100um, but the disclosure is not limited thereto. As an example, the second separation distance L2 may be greater than 150 um. As an example, the second separation distance L2 may be less than 50um.

According to an embodiment, the interposer PCB 420 may include the plurality of first vias 510 having the first separation distance L1, and the first solder layer 540 having the third separation distance L3 secured in relation to the second solder layer 640.

According to an embodiment, since the interposer PCB 420 includes the first solder layer 540 of which the third separation distance L3 is secured, a possibility that an electrical error occurs may be reduced. For example, since the third separation distance L3 is formed to be longer than the second separation distance L2, the interposer PCB 420 may prevent a problem in which an electric short occurs between the second solder layer 640 and the first solder layer 540. For example, since the third separation distance L3 between the first solder layer 540 and the different solder layer 640 is secured, the interposer PCB 420 may prevent the first signal transferred through the first soler layer 540 from flowing to the second solder layer 640.

According to an embodiment, the third conductive pad 533 and the third solder layer 542 may refer to the first conductive pad 530 and the first solder layer 540.

According to an embodiment, the conductive pad and solder layer of the interposer PCB 420 may be disposed to both faces of the insulating layer 520. For example, the conductive pad and the solder layer may be disposed to the first face 521 and second face 522 of the insulating layer 520.

According to an embodiment, the third conductive pad 533 may be disposed on the second face 522 to cover the third holes 512 of the plurality of first vias 510 formed on the second face 522. For example, since the third conductive pad 533 is electrically coupled to the plurality of first vias 510, the third conducive pad 533 may transfer to a second PCB (e.g., 412 of FIG. 4) the first signal transferred from the plurality of first vias 510.

According to an embodiment, the first solder layer 542 may be disposed on the third conductive pad 533, and may be formed of a smaller width than the third conductive pad 533. For example, the third conductive pad 533 may extend by the third width W3 in a first direction (e.g., a positive x-direction or a negative x-direction) along the second face 522 of the insulating layer 520, and the third solder layer may extend by the fourth width W4 smaller than the third width W3 in the first direction. For example, the third width W3 and the fourth width W4 may be substantially the same as the first width W1 of the first conductive pad 530 and the second width W2 of the second solder layer 640, but the disclosure is not limited thereto.

According to an embodiment, since the interposer PCB 420 further includes the third conductive pad 533, which is disposed on the second face 522 of the insulating layer 520, and the third solder layer 542, the first signal transferred from the second PCB 412 may be transferred to the first PCB 411. As an example, the interposer PCB 420 may transfer to the second PCB 412 a first electrical signal transferred from the first PCB 411.

According to an embodiment, the second via 610 may also refer to a conductive pad and solder layer disposed on the second face 522 of the insulating layer 520.

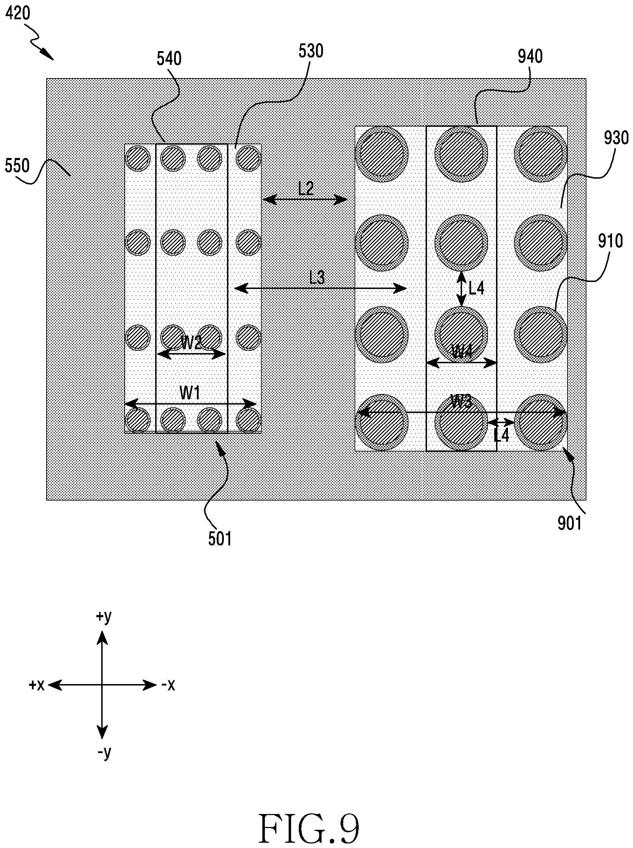

FIG. 9 illustrates a disposition of vias in an interposer PCB according to an embodiment.

Unlike in FIG. 7 and FIG. 8, not only the first via group 501 but also a second via group 901 is illustrated together in FIG. 9.

According to an embodiment, an interposer PCB 420 of FIG. 9 may include the second via group 901, unlike in FIG. 7 and FIG. 8.

According to an embodiment, content repeated in the embodiment described with reference to FIG. 5 to FIG. 8 will be omitted in the description of the embodiment of FIG. 9.

According to an embodiment, the interposer PCB 420 may include the plurality of second vias 910. According to an embodiment, the plurality of second vias 910 may refer to the second via 610 of FIG. 7 and FIG. 8. For example, the plurality of second vias 910 may penetrate the insulating layer 520 to couple the first face 521 and second face 522 of the insulating layer 520. For example, the plurality of second vias 910 may be used as a second transmission path through which a second signal different from a first signal of the plurality of first vias 510 passes.

According to an embodiment, the plurality of second vias 910 used as the second transmission path of the same second signal may be collectively referred to as the second via group 901.

According to an embodiment, since the second via group 901 is used as the second transmission path of the second signal, there may be no problem even if an electrical short of the second signal occurs between the plurality of second vias 910. For example, even if the second signal transferred from one via among the plurality of second vias 910 is transferred to another via among the plurality of second vias 910, a signal interference problem may not occur.

According to an embodiment, since the interposer PCB 420 decreases in size, a region where another electronic part is disposed may increase inside the electronic device 100. For example, since the interposer PCB 420 decreases in size, a space where the battery 320 is disposed may be additionally secured inside the electronic device 100. According to an embodiment, since the space where the battery 320 is disposed is additionally secured, user's convenience or usability may increase.

According to an embodiment, since the electrical short problem does not occur between the plurality of second vias 910, a fourth separation distance L4 between the plurality of second vias 910 may be shorter than a separation distance L1 between the second via 910 and the plurality of first vias 510.

According to an embodiment, a decrease in the fourth separation distance L4 between the plurality of second vias 910 may lead to a decrease in a size of the interposer PCB 420. As an example, since the fourth separation distance L4 between the plurality of second vias 910 decreases, the interposer PCB 420 may include more vias than the interposer PCB having the same length.

According to an embodiment, although it is illustrated in FIG. 9 that the fourth separation distance L4 between the plurality of second vias 910 is formed in a first direction (e.g., a y-direction), the disclosure is not limited thereto. As an example, the fourth separation distance L4 may be formed in a second direction (e.g., a x-direction). As an example, the fourth separation distance L4 may be formed of a length between one second via among the plurality of second vias 910 and another second via located in a diagonal direction (e.g., a xy-direction).

In addition, according to an embodiment, the second via group 901 and the first via group 501 are spaced apart by a specific distance, thereby being electrically cut off. For example, since the second solder layer 940 and the first solder layer 540 are spaced apart by the third separation distance L3, the second via group 901 and the first via group 501 may be electrically cut off.

According to an embodiment, the third separation distance L3 may include a separation distance between the first solder layer 540 and the second solder layer 640. According to an embodiment, the second separation distance L2 described below may include a separation distance between the first conductive pad 530 and the second conductive pad 930.

According to an embodiment, since the third separation distance L3 is formed to be longer than the second separation distance L2, an electrical short problem occurring between the second solder layer 940 and the first solder layer 540 may be reduced. For example, since the third separation distance L3 is secured, a first signal transferred through the first solder layer 540 may be prevented from flowing to the second solder layer 940.

According to an embodiment, an embodiment related to the first conductive pad 530, the first solder layer 540, the second conductive pad 930, and the second solder layer 940 may refer to the first conductive pad 530, first solder layer 540, second conductive pad 630, and second solder layer 640 of FIG. 5 to FIG. 8.

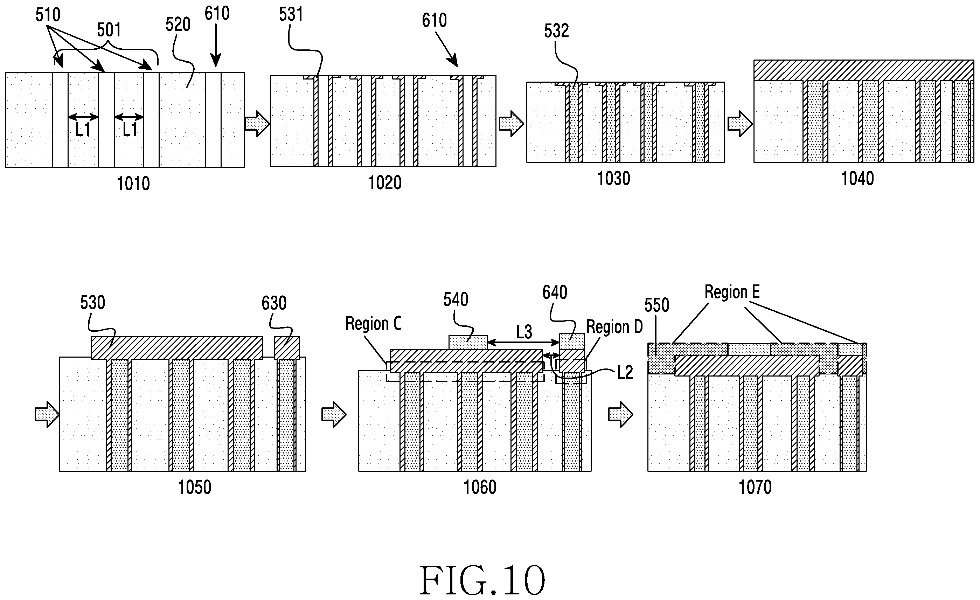

FIG. 10 is a flowchart illustrating a process of manufacturing an interposer PCB according to an embodiment.

FIG. 10 illustrates a method of manufacturing the interposer PCB 420 of FIG. 4.

The interposer PCB 420 of the method of manufacturing the interposer PCB 420 illustrated in FIG. 10 may refer to the interposer PCB 420 of FIG. 5 to FIG. 9. For example, the interposer PCB 420 of FIG. 10 may include the plurality of first vias 510 and the second via 610.

According to an embodiment, a process 1010 may include an operation of forming the plurality of first vias 510 which penetrate the insulating layer 520. For example, the process 1010 may include an operation of forming the plurality of first vias 510 which penetrate the insulating layer 520, and the second via 610 spaced apart from the plurality of first vias 510.

According to an embodiment, the plurality of first vias 510 may be used as a first transmission path through which a first signal passes, and the second via 610 may be used as a second transmission path through which a second signal passes.

According to an embodiment, the plurality of first vias 510 may be formed spaced apart by the first separation distance L1. According to an embodiment, the first separation distance L1 may be shorter than a separation distance between the plurality of first vias 510 and the second via 610.

According to an embodiment, the plurality of first vias 510 may be used as a first transmission path for transferring the first signal. According to an embodiment, a signal error may not occur between the plurality of first vias 510. For example, even if the first signal transferred from one via among the plurality of first vias 510 is transferred to another via among the plurality of first vias 510, a signal interference problem may not occur.

According to an embodiment, since there is no error occurring in the first signal between the plurality of first vias 510, the first separation distance L1 between the plurality of vias 510 may be shorter than a separation distance between the plurality of first vias 510 and the second via 610 used as the second transmission path of a different second signal.

According to an embodiment, a decrease in the first separation distance L1 between the plurality of first vias 510 may lead to a decrease in a size of the interposer PCB 420. As an example, since the first separation distance L1 between the plurality of first vias 510 decreases, the interposer PCB 420 may include more vias than the interposer PCB having the same length.

According to an embodiment, a process 1020 may include an operation of applying a first conductive material to the inner face 531 of the plurality of first vias 510. For example, the first conductive material may include copper (Cu).

According to an embodiment, a process 1030 may include an operation of injecting an insulating material to the plurality of first vias 510 applied with the first conductive material. According to an embodiment, since the insulating material is injected, rigidity of the plurality of first vias 510 may be secured.

According to an embodiment, a process 1040 may include an operation of applying on the insulating layer 520 a second conductive material covering the holes 511 and 512 of the plurality of first vias 510 to which the insulating material is injected. The second conductive material applied on the insulating layer 520 may be used to form conductive pads, described below, on the insulating layer 520.

According to an embodiment, the holes 511 and 512 may be formed on both faces (e.g., the first face 521 and the second face 422) of the insulating layer 520. For example, the holes 511 and 512 may include the first holes 511 and the third holes 512. The first holes 511 may be formed on the first face 521 of the insulating layer 520, and the third holes 512 may be formed on the second face 522 of the insulating layer 520.

According to an embodiment, a process 1050 may include an operation of forming the first conductive pad 530 by etching a second region (a region D) other than a first region (a region C) covering the first holes 511. For example, the process 1050 may include an operation of forming the first conductive pad 530 by etching the second region (the region D) other than the first region (the region C), and forming the second conductive pad 630 by etching a third region (a region E) other than the first region (the region C) and the second region (the region D).

According to an embodiment, the single first conductive pad 530 may cover the plurality of first vias 510.

According to an embodiment, since the single first conductive pad 530 covers the plurality of first vias 510, the first solder layer 540 disposed on the first conductive pad 530 may be formed of a narrower width than the first conductive pad 530. For example, even if the first solder layer 540 is formed of the narrower width than the first conductive pad 530, a signal transferred from the plurality of first vias 510 may be transferred to the first solder layer 540 through the first conductive pad 530.

According to an embodiment, since the width of the first solder layer 540 decreases, a separation distance between the first solder layer 540 and a different second solder layer (not shown) may be secured.

According to an embodiment, since the separation distance between the first solder layer 540 and the different second solder layer 640 is secured, an electrical short between the first solder layer 540 and the second soler layer 640 may be avoided.

According to an embodiment, a process 1060 may include an operation of forming the first solder layer 540 having a narrower width than the first conductive pad 530, on the first conductive pad 530. For example, the process 1060 may include an operation of forming the first solder layer 540 having a narrower width than the first conductive pad 530, on the first conductive pad 530, and an operation of forming the second solder layer 640 on the second conductive pad 630.

According to an embodiment, the first conductive pad 530 may be formed of a first width W1, and the first solder layer 540 may be formed of a second width W2 smaller than the first width W1, but the disclosure is not limited thereto. For example, the first solder layer 540 may be formed of the first width W1.

According to an embodiment, since the first solder layer 540 is formed of the second width W2 smaller than the first width W1, a separation distance between the first solder layer 540 and a second solder layer which transfers another signal may be secured. For example, the first conductive pad 530 and the second conductive pad 630 may be spaced apart by a second separation distance L2, and the first solder layer 540 may be separated from the second solder layer 640 by a third separation distance L3 longer than the second separation distance L2.

According to an embodiment, since the third separation distance L3 is formed to be longer than the second separation distance L2, an electrical short between the first solder layer 540 and the second solder layer 640 may be prevented, and the first conductive pad 530 and the second conductive pad 630 may be disposed adjacent to each other on the insulating layer 520.

In an example, since the interposer PCB 420 includes the first solder layer 540 of which the third separation distance L3 is secured, a possibility that an electrical error occurs may be reduced. For example, since the third separation distance L3 is formed to be longer than the second separation distance L2, the interposer PCB 420 may prevent a problem in which an electric short occurs between the second solder layer 640 and the first solder layer 540. For example, since the third separation distance L3 between the first solder layer 540 and the different solder layer 640 is secured, the interposer PCB 420 may prevent a first signal transferred through the first soler layer 540 from flowing to the second solder layer 640.

According to an embodiment, the method of manufacturing the interposer PCB 420 may include a process 1070 of forming a solder resist. For example, the process 1060 may include an operation of forming the solder resist 550 in a space where the first conductive pad 530 and the first solder layer 540 are not disposed, in a second region (a region D). As an example, the process 1060 may include an operation of forming the soler resist 550 in the space where the first conductive pad 530 and the first solder layer 540 are not disposed, in a third region (a region E).

As an example, the solder resist 550 may be formed by being spaced apart in part from the first solder layer 540. For example, an empty space may be formed between the solder resist 550 and the first solder layer 540.

According to an embodiment, since the solder resist 550 is formed in the third region (the region E), one face (421 of FIG. 4) of the interposer PCB 420 may be formed to be flat.

According to an embodiment, the process 1060 and the process 1070 may not be limited to this order. For example, the process 1060 may be included after the process 1070.

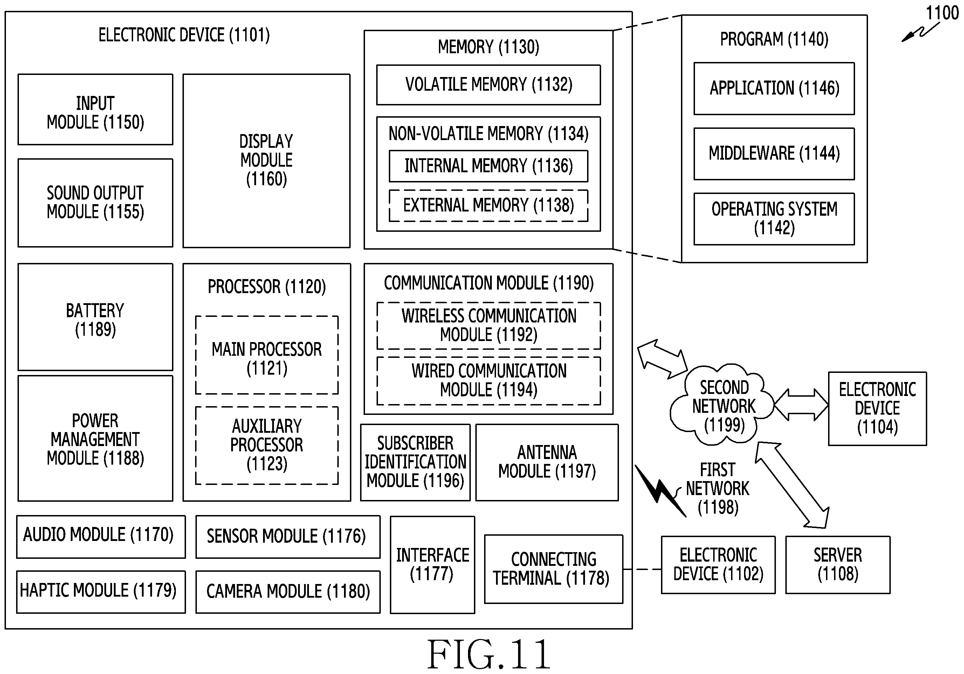

FIG. 11 is a block diagram illustrating an electronic device 1101 in a network environment 1100 according to various embodiments. Referring to FIG. 11, the electronic device 1101 in the network environment 1100 may communicate with an electronic device 1102 via a first network 1198 (e.g., a short-range wireless communication network), or an electronic device 1104 or a server 1108 via a second network 1199 (e.g., a long-range wireless communication network). According to an embodiment, the electronic device 1101 may communicate with the electronic device 1104 via the server 1108. According to an embodiment, the electronic device 1101 may include a processor 1120, memory 1130, an input module 1150, a sound output module 1155, a display module 1160, an audio module 1170, a sensor module 1176, an interface 1177, a connecting terminal 1178, a haptic module 1179, a camera module 1180, a power management module 1188, a battery 1189, a communication module 1190, a subscriber identification module 1196, or an antenna module 1197. In an embodiment, at least one (e.g., the connecting terminal 1178) of the components may be omitted from the electronic device 1101, or one or more other components may be added. According to an embodiment, some (e.g., the sensor module 1176, the camera module 1180, or the antenna module 1197) of the components may be integrated as a single component (e.g., the display module 1160).

The processor 1120 may execute, for example, software (e.g., a program 1140) to control at least one different component (e.g., a hardware or software component) of the electronic device 1101 coupled with the processor 1120, and may perform various data processing or computation. According to an embodiment, as at least part of the data processing or computation, the processor 1120 may store a command or data received from another component (e.g., the sensor module 1176 or the communication module 1190) in volatile memory 1132, process the command or the data stored in the volatile memory 1132, and store resulting data in non-volatile memory 1134. According to an embodiment, the processor 1120 may include a main processor 1121 (e.g., a central processing unit or an application processor), or an auxiliary processor 1123 (e.g., a graphics processing unit, a neural processing unit (NPU), an image signal processor, a sensor hub processor, or a communication processor) that is operable independently from, or in conjunction with, the main processor 1121. For example, when the electronic device 1101 includes the main processor 1121 and the auxiliary processor 1123, the auxiliary processor 1123 may be configured to use lower power than the main processor 1121 or to be specified for a designated function. The auxiliary processor 1123 may be implemented as separate from, or as part of the main processor 1121.

The auxiliary processor 1123 may control at least some of functions or states related to at least one component (e.g., the display module 1160, the sensor module 1176, or the communication module 1190) among the components of the electronic device 1101, instead of the main processor 1121 while the main processor 1121 is in an inactive (e.g., sleep) state, or together with the main processor 1121 while the main processor 1121 is in an active state (e.g., executing an application). According to an embodiment, the auxiliary processor 1123 (e.g., an image signal processor or a communication processor) may be implemented as part of another component (e.g., the camera module 1180 or the communication module 1190) functionally related to the auxiliary processor 123. According to an embodiment, the auxiliary processor 1123 (e.g., the neural processing unit) may include a hardware structure specified for artificial intelligence model processing. The artificial intelligence model may be generated via machine learning. Such learning may be performed, e.g., by the electronic device 1101 where the artificial intelligence is performed or via a separate server (e.g., the server 1108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1130 may store various data used by at least one component (e.g., the processor 1120 or the sensor module 1176) of the electronic device 1101. The data may include, for example, software (e.g., the program 1140) and input data or output data for a command related thereto. The memory 1130 may include the volatile memory 1132 or the non-volatile memory 1134.

The program 1140 may be stored in the memory 1130 as software, and may include, for example, an operating system 1142, middleware 1144, or an application 1146.

The input module 1150 may receive a command or data to be used by components (e.g., the processor 1120) of the electronic device 1101, from the outside (e.g., a user) of the electronic device 1101. The input module 1150 may include, for example, a microphone, a mouse, a keyboard, keys (e.g., buttons), or a digital pen (e.g., a stylus pen).

The sound output module 1155 may output sound signals to the outside of the electronic device 1101. The sound output module 1155 may include, for example, a speaker or a receiver. The speaker may be used for general purposes, such as multimedia playback or recording playback. The receiver may be used for receiving incoming calls. According to an embodiment, the receiver may be implemented as separate from, or as part of the speaker.

The display module 1160 may visually provide information to the outside (e.g., a user) of the electronic device 1101. The display 1160 may include, for example, a display, a hologram device, or a projector and control circuitry to control a corresponding one of the display, hologram device, and projector. According to an embodiment, the display 1160 may include a touch sensor configured to detect a touch, or a pressure sensor configured to measure the intensity of a force generated by the touch.

The audio module 1170 may convert a sound into an electrical signal and vice versa. According to an embodiment, the audio module 1170 may obtain the sound via the input module 1150, or output the sound via the sound output module 1155 or a headphone of an external electronic device (e.g., an electronic device 1102) directly or wirelessly coupled with the electronic device 1101.

The sensor module 1176 may detect an operational state (e.g., power or temperature) of the electronic device 1101 or an environmental state (e.g., a state of a user) external to the electronic device 101, and then generate an electrical signal or data value corresponding to the detected state. According to an embodiment, the sensor module 1176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 1177 may support one or more specified protocols to be used for the electronic device 1101 to be coupled with the external electronic device (e.g., the electronic device 1102) directly or wirelessly. According to an embodiment, the interface 1177 may include, for example, a High Definition Multimedia Interface (HDMI), a Universal Serial Bus (USB) interface, a Secure Digital (SD) card interface, or an audio interface.

The connecting terminal 1178 may include a connector via which the electronic device 1101 may be physically connected with the external electronic device (e.g., the electronic device 1102). According to an embodiment, the connecting terminal 1178 may include, for example, a HDMI connector, a USB connector, a SD card connector, or an audio connector (e.g., a headphone connector).

The haptic module 1179 may convert an electrical signal into a mechanical stimulus (e.g., a vibration or motion) or electrical stimulus which may be recognized by a user via his tactile sensation or kinesthetic sensation. According to an embodiment, the haptic module 1179 may include, for example, a motor, a piezoelectric element, or an electric stimulator.

The camera module 1180 may capture still images or moving images. According to an embodiment, the camera module 1180 may include one or more lenses, image sensors, image signal processors, or flashes.

The power management module 1188 may manage power supplied to the electronic device 1101. According to an embodiment, the power management module 1188 may be implemented as at least part of, for example, a Power Management Integrated Circuit (PMIC).

The battery 1189 may supply power to at least one component of the electronic device 1101. According to an embodiment, the battery 1189 may include, for example, a primary cell which is not rechargeable, a secondary cell which is rechargeable, or a fuel cell.

The communication module 1190 may support establishing a direct (e.g., wired) communication channel or a wireless communication channel between the electronic device 1101 and the external electronic device (e.g., the electronic device 1102, the electronic device 1104, or the server 1108) and performing communication via the established communication channel. The communication module 1190 may include one or more communication processors that are operable independently from the processor 1120 (e.g., the application processor) and supports a direct (e.g., wired) communication or a wireless communication. According to an embodiment, the communication module 1190 may include a wireless communication module 1192 (e.g., a cellular communication module, a short-range wireless communication module, or a global navigation satellite system (GNSS) communication module) or a wired communication module 1194 (e.g., a local area network (LAN) communication module or a power line communication module). A corresponding one of these communication modules may communicate with the external electronic device 1104 via a first network 1198 (e.g., a short-range communication network, such as Bluetooth, Wireless-Fidelity (Wi-Fi) direct, or Infrared Data Association (IrDA)) or a second network 1199 (e.g., a long-range communication network, such as a legacy cellular network, a 5G network, a next-generation communication network, the Internet, or a computer network (e.g., LAN or Wide Area Network (WAN)). These various types of communication modules may be implemented as a single component (e.g., a single chip), or may be implemented as multi components (e.g., multi chips) separate from each other. The wireless communication module 1192 may identify or authenticate the electronic device 1101 in a communication network, such as the first network 1198 or the second network 1199, using subscriber information (e.g., International Mobile Subscriber Identity (IMSI)) stored in the subscriber identification module 1196.

The wireless communication module 1192 may support a 5G network after a 4G network, and next-generation communication technology, e.g., New Radio (NR) access technology. The NR access technology may support enhanced Mobile Broadband (eMBB), Massive Machine Type Communications (mMTC), or Ultra-Reliable and Low-Latency Communications (URLLC). The wireless communication module 1192 may support a high-frequency band (e.g., the mmWave band) to achieve, e.g., a high data transmission rate. The wireless communication module 1192 may support various technologies for securing performance on a high-frequency band, such as, e.g., beamforming, massive Multiple-Input and Multiple-Output (massive MIMO), Full Dimensional MIMO (FD-MIMO), array antenna, analog beam-forming, or large scale antenna. The wireless communication module 1192 may support various requirements specified in the electronic device 1101, an external electronic device (e.g., the electronic device 1104), or a network system (e.g., the second network 1199). According to an embodiment, the wireless communication module 1192 may support a peak data rate (e.g., 20Gbps or more) for implementing eMBB, loss coverage (e.g., 164dB or less) for implementing mMTC, or U-plane latency (e.g., 0.5ms or less for each of Downlink (DL) and Uplink (UL), or a round trip of 1ms or less) for implementing URLLC.

The antenna module 1197 may transmit or receive a signal or power to or from the outside (e.g., the external electronic device). According to an embodiment, the antenna module 1197 may include one antenna including a radiator formed of a conductive body or conductive pattern formed on a substrate (e.g., a Printed Circuit Board (PCB)). According to an embodiment, the antenna module 1197 may include a plurality of antennas (e.g., an antenna array). In this case, at least one antenna appropriate for a communication scheme used in a communication network, such as the first network 1198 or the second network 1199, may be selected from the plurality of antennas by, e.g., the communication module 1190. The signal or the power may then be transmitted or received between the communication module 1190 and the external electronic device via the selected at least one antenna. According to an embodiment, other parts (e.g., Radio Frequency Integrated Circuit (RFIC)) than the radiator may be further formed as part of the antenna module 1197. According to various embodiments, the antenna module 1197 may form a mmWave antenna module. According to an embodiment, the mmWave antenna module may include a printed circuit board, a RFIC disposed on a first face (e.g., the bottom face) of the printed circuit board, or adjacent to the first face and capable of supporting a designated high-frequency band (e.g., the mmWave band), and a plurality of antennas (e.g., array antennas) disposed on a second face (e.g., the top or side face) of the printed circuit board, or adjacent to the second face and capable of transmitting or receiving signals of the designated high-frequency band.

At least some of the above-described components may be coupled mutually and communicate signals (e.g., commands or data) therebetween via an inter-peripheral communication scheme (e.g., a bus, General Purpose Input and Output (GPIO), Serial Peripheral Interface (SPI), or Mobile Industry Processor Interface (MIPI)).

According to an embodiment, commands or data may be transmitted or received between the electronic device 1101 and the external electronic device 1104 via the server 1108 coupled with the second network 1199. Each of the external electronic devices 1102 or 1104 may be a device of the same or a different type from the electronic device 1101. According to an embodiment, all or some of operations to be executed at the electronic device 1101 may be executed at one or more of the external electronic devices 1102, 1104, or 1108. For example, if the electronic device 1101 has to perform a function or a service automatically, or in response to a request from a user or another device, the electronic device 1101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1101. The electronic device 1101 may provide the outcome, with or without further processing of the outcome, as at least part of a reply to the request. To this end, for example, a cloud computing, distributed computing, Mobile Edge Computing (MEC), or client-server computing technology may be used. The electronic device 1101 may provide ultra low-latency services using, e.g., distributed computing or mobile edge computing. In another embodiment, the external electronic device 1104 may include an Internet-of-Things (IoT) device. The server 1108 may be an intelligent server using machine learning and/or a neural network. According to an embodiment, the external electronic device 1104 or the server 1108 may be included in the second network 1199. The electronic device 1101 may be applied to intelligent services (e.g., smart home, smart city, smart car, or healthcare) based on 5G communication technology or loT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an Application-Specific Integrated Circuit (ASIC).

Various embodiments as set forth herein may be implemented as software (e.g., the program 1140) including one or more instructions that are stored in a storage medium (e.g., the internal memory 1136 or the external memory 1138) that is readable by a machine (e.g., the electronic device 1101). For example, a processor (e.g., the processor 1120) of the machine (e.g., the electronic device 1101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., Compact Disc Read Only Memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated as a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments of the disclosure, an interposer PCB may include an insulating layer which includes a first face and a second face opposite to the first face, a first via group which penetrates the insulating layer to connect the first face and the second face, and includes a plurality of first vias formed spaced apart from each other, the plurality of first vias included in the first via group being used as a first transmission path through which a first signal passes, a first conductive pad which is disposed on the first face to cover first holes of the plurality of first vias, formed on the first face, and is electrically coupled to the plurality of first vias, and a first solder layer which is disposed on the first conductive pad. The first conductive pad may extend by a first width in a first direction along the first face of the insulating layer. The first solder layer may extend by a second width smaller than the first width in the first direction.

According to an embodiment, the interposer PCB may include a second via which penetrates the insulating layer to connect the first face and the second face, and is spaced apart from the first via group including the plurality of first vias, a second conductive pad which is disposed on the first face to be spaced apart from the first conductive pad and to cover a second hole of the second via, and is electronically coupled to the second via, and a second solder layer which is disposed on the second conductive pad. The second via may be used as a second transmission path through which a second signal different from the first signal is transmitted. The second solder layer may be disposed spaced apart from the first solder layer so as to be electrically cut off from the first solder layer.

According to an embodiment, the first conductive pad and the second conductive pad may be spaced apart by a second separation distance. The first solder layer may be spaced apart from the second solder layer by a third separation distance longer than the second separation distance.

According to an embodiment, the second separation distance may be within 50um to 150um. The third separation distance may be within 350um to 550um.

According to an embodiment, the electronic device may further include a solder resist layer formed in a space where the first conductive pad and the first solder layer are not disposed, on the first face of the insulating layer.

According to various embodiments of the disclosure, a method of manufacturing an interposer PCB may include forming a plurality of first vias which penetrate an insulating layer, applying a first conductive material to an inner face of the plurality of vias, injecting an insulating material to the plurality of first vias applied with the conductive material, applying a second conductive material covering holes of the plurality of first vias, to which the insulating material is injected, onto the insulating layer, the holes being formed on both faces of the insulating layer, forming a first conductive pad by etching a second region other than a first region of the insulating layer of which the holes are covered by the second conductive material, and applying a first solder layer, on the formed first conductive pad, with a width narrower than the first conductive pad.

According to an embodiment, the method may further include forming a second via which penetrates the insulating layer, and is spaced apart from a first via group including the plurality of first vias, on the second region of the insulating layer, applying a second conductive material covering a second hole of the second via onto the insulating layer, the holes being formed on both faces of the insulating layer, forming a second conductive path by etching a third region other than the first region and second region of the insulating layer of which the second hole is covered by the second conductive material, and forming a second solder layer on the formed second conductive pad. The first vias may be used as a first transmission path through which a first signal passes. The second via may be used as a second transmission path through which a second signal passes. The second solder layer may be disposed spaced apart from the first solder layer so as to be electrically cut off from the first solder layer.

According to an embodiment, the first conductive pad and the second conductive pad may be spaced apart by a first separation distance. The first solder layer may be spaced apart from the second solder layer by a second separation distance longer than the first separation distance.

According to an embodiment, the method may further include forming a solder resist in a space where the first conductive pad and the first solder layer are not disposed, on the second region of the insulating layer. According to various embodiments of the disclosure, an electronic device may include a housing which forms an exterior of at least part of the electronic device, a battery which is disposed to an inner space of the electronic device formed by the housing, and a Printed Board Assembly (PBA) which is disposed between the battery and a side member of the housing in the inner space, the PBA including a first Printed Circuit Board (PCB), a second PCB, and an interposer PCB which is disposed between the first PCB and the second PCB to connect the first PCB and the second PCB. The interposer PCB may include an insulating layer which includes a first face and a second face opposite to the first face, a first via group which penetrates the insulating layer to connect the first face and the second face, and includes a plurality of first vias formed spaced apart from each other, the plurality of first vias included in the first via group being used as a first transmission path through which a first signal passes, a first conductive pad which is disposed on the first face to cover holes of the plurality of first vias, formed on the first face, and is electrically coupled to the plurality of first vias, and a first solder layer which is disposed on the first conductive pad. The first conductive pad may extend by a first width in a first direction along the first face of the insulating layer. The first solder layer may extend by a second width smaller than the first width in the first direction.

According to an embodiment, the electronic device may further include a second via which penetrates the insulating layer to connect the first face and the second face, and is spaced apart from the first via group including the plurality of first vias, a second conductive pad which is disposed on the first face to be spaced apart from the first conductive pad and to cover a second hole of the second via, and is electronically coupled to the second via, and a second solder layer which is disposed on the second conductive pad. The second via may be used as a second transmission path through which a second signal different from the first signal is transmitted. The second solder layer may be disposed spaced apart from the first solder layer so as to be electrically cut off from the first solder layer.

According to an embodiment, a first separation distance between the plurality of first vias may be shorter than a separation distance between the first via group and the second via group.

According to an embodiment, the first separation distance between the plurality of first vias may be within 100umm to 200umm.

According to an embodiment, the first conductive pad and the second conductive pad may be spaced apart by a second separation distance. The first solder layer may be spaced apart from the second solder layer by a third separation distance longer than the second separation distance.

According to an embodiment, the second separation distance may be within 50um to 150um. The third separation distance may be within 350um to 550um.

According to an embodiment, a solder resist layer may be formed in a space where the first conductive pad and the first solder layer are not disposed, on the first face of the insulating layer.

According to an embodiment, the electronic device may include a third conductive pad which is disposed on the second face to cover third holes of the plurality of first vias formed on the second face, and is electrically coupled to the first via group, and a third solder layer which is disposed on the third conductive pad. The third conductive pad may extend by a third width in the first direction along a second face of the insulating layer. The third solder layer may extend by a fourth width smaller than the third width in the first direction.

According to an embodiment, the electronic device may further include a second via group which penetrates the insulating layer to connect the first face and the second face, and includes a plurality of second vias used as a second transmission path through which a second signal different from the first signal passes. The second via group may be spaced apart from the first via group by a fifth separation distance so as to be electrically cut off from the first via group.

According to an embodiment, an inner space of the plurality of first vias may be filled with an insulating material.

According to an embodiment, the first via group may be formed at a portion adjacent to a power Integrated Circuit (IC) or battery charger IC which is disposed to the inner space of the electronic device, on the insulating layer.

## Claims

1. An electronic device comprising:
a housing forming an exterior of at least part of the electronic device;
a battery disposed to an inner space of the electronic device formed by the housing; and
a Printed Board Assembly (PBA) disposed between the battery and a side member of the housing in the inner space, the PBA including a first Printed Circuit Board (PCB), a second PCB, and an interposer PCB disposed between the first PCB and the second PCB to connect the first PCB and the second PCB,
wherein the interposer PCB comprises:
an insulating layer including a first face and a second face opposite to the first face;
a first via group penetrating the insulating layer to connect the first face and the second face, and including a plurality of first vias formed spaced apart from each other, the plurality of first vias included in the first via group being used as a first transmission path through which a first signal passes;
a first conductive pad disposed on the first face to cover holes of the plurality of first vias, formed on the first face, and electrically coupled to the plurality of first vias; and
a first solder layer disposed on the first conductive pad,
wherein the first conductive pad extends by a first width in a first direction along the first face of the insulating layer, and
wherein the first solder layer extends by a second width smaller than the first width in the first direction.

2. The electronic device of claim 1, further comprising:
a second via penetrating the insulating layer to connect the first face and the second face, and spaced apart from the first via group including the plurality of first vias;
a second conductive pad disposed on the first face to be spaced apart from the first conductive pad and to cover a second hole of the second via, and electronically coupled to the second via; and
a second solder layer disposed on the second conductive pad,
wherein the second via is used as a second transmission path through which a second signal different from the first signal is transmitted, and
wherein the second solder layer is disposed spaced apart from the first solder layer so as to be electrically cut off from the first solder layer.

3. The electronic device of claim 2, wherein a first separation distance between the plurality of first vias is shorter than a separation distance between the first via group and the second via group.

4. The electronic device of claim 3, wherein the first separation distance between the plurality of first vias is within 100umm to 200umm.

5. The electronic device of claim 2,
wherein the first conductive pad and the second conductive pad are spaced apart by a second separation distance, and
wherein the first solder layer is spaced apart from the second solder layer by a third separation distance longer than the second separation distance.

6. The electronic device of claim 5,
wherein the second separation distance is within 50um to 150um, and
wherein the third separation distance is within 350um to 550um.

7. The electronic device of claim 1, wherein a solder resist layer is formed in a space where the first conductive pad and the first solder layer are not disposed, on the first face of the insulating layer.

8. The electronic device of claim 1, further comprising:
a third conductive pad disposed on the second face to cover third holes of the plurality of first vias formed on the second face, and electrically coupled to the first via group; and
a third solder layer disposed on the third conductive pad,
wherein the third conductive pad extends by a third width in the first direction along a second face of the insulating layer, and
wherein the third solder layer extends by a fourth width smaller than the third width in the first direction.

9. The electronic device of claim 1, further comprising
a second via group penetrating the insulating layer to connect the first face and the second face, and including a plurality of second vias used as a second transmission path through which a second signal different from the first signal passes,
wherein the second via group is spaced apart from the first via group by a fifth separation distance so as to be electrically cut off from the first via group.

10. The electronic device of claim 1, wherein an inner space of the plurality of first vias is filled with an insulating material.

11. The electronic device of claim 1, wherein the first via group is formed at a portion adjacent to a power Integrated Circuit (IC) or battery charger IC disposed to the inner space of the electronic device, on the insulating layer.

12. A method of manufacturing an interposer Printed Circuit Board (PCB), comprising:
forming a plurality of first vias penetrating an insulating layer;
applying a first conductive material to an inner face of the plurality of vias;
injecting an insulating material to the plurality of first vias applied with the conductive material;
applying a second conductive material covering holes of the plurality of first vias, to which the insulating material is injected, onto the insulating layer, the holes being formed on both faces of the insulating layer;
forming a first conductive pad by etching a second region other than a first region of the insulating layer of which the holes are covered by the second conductive material; and
applying a first solder layer, on the formed first conductive pad, with a width narrower than the first conductive pad.

13. The method of claim 12, further comprising:
forming a second via penetrating the insulating layer, and spaced apart from a first via group including the plurality of first vias, on the second region of the insulating layer;
applying a second conductive material covering a second hole of the second via onto the insulating layer, the holes being formed on both faces of the insulating layer;
forming a second conductive path by etching a third region other than the first region and second region of the insulating layer of which the second hole is covered by the second conductive material; and
forming a second solder layer on the formed second conductive pad,
wherein the first vias are used as a first transmission path through which a first signal passes,
wherein the second via is used as a second transmission path through which a second signal passes, and
wherein the second solder layer is disposed spaced apart from the first solder layer so as to be electrically cut off from the first solder layer.

14. The method of claim 13,
wherein the first conductive pad and the second conductive pad are spaced apart by a first separation distance, and
wherein the first solder layer is spaced apart from the second solder layer by a second separation distance longer than the first separation distance.

15. The method of claim 12, further comprising forming a solder resist in a space where the first conductive pad and the first solder layer are not disposed, on the second region of the insulating layer.
